**Europäisches Patentamt**

**European Patent Office**

**Office européen des brevets**

(19)

(11) Veröffentlichungsnummer: **0 218 179**
**B1**

(12) **EUROPÄISCHE PATENTSCHRIFT**

(45) Veröffentlichungstag der Patentschrift:
**11.04.90**

(51) Int. Cl.⁴: **H03G 3/34**

(21) Anmeldenummer: **86113455.9**

(22) Anmeldetag: **01.10.86**

(54) **Schaltungsanordnung zur Signalverstärkung.**

(30) Priorität: **08.10.85 DE 3535882**

(43) Veröffentlichungstag der Anmeldung:
**15.04.87 Patentblatt 87/16**

(45) Bekanntmachung des Hinweises auf die Patenterteilung:
**11.04.90 Patentblatt 90/15**

(84) Benannte Vertragsstaaten:
**DE FR GB IT**

(56) Entgegenhaltungen:
**GB-A- 2 027 306**
**GB-A- 2 111 334**
**GB-A- 2 151 887**
**US-A- 4 300 102**

(73) Patentinhaber: **Licentia Patent-Verwaltungs-GmbH,**
**Theodor-Stern-Kai 1, D-6000 Frankfurt/Main 70(DE)**
Patentinhaber: **TELEFUNKEN electronic GmbH,**
**Theresienstrasse 2, D-7100 Heilbronn(DE)**

(72) Erfinder: **Forster, Gerhard, Dipl.-Phys.,**
**Wörtstrasse 96/3, D-7900 Ulm(DE)**
Erfinder: **Hirsch, Konrad, Dipl.-Ing. (FH), Biberacher**
**Strasse 75, D-7900 Ulm(DE)**

(74) Vertreter: **Amersbach, Werner, Dipl.-Ing., Licentia**
**Patent-Verwaltungs-GmbH Theodor-Stern-Kai 1,**
**D-6000 Frankfurt 70(DE)**

## Beschreibung

Die Erfindung betrifft eine Schaltungsanordnung zur Signalverstärkung der im Oberbegriff des Patentanspruchs 1 genannten Art.

Eine Schaltungsanordnung der eingangs genannten Art ist z.B. bekannt aus der US-PS 4 464 632. Sie dient zur Lautstärkesteuerung von NF-Signalen und soll unabhängig von Schwankungen der Versorgungsspannung und der Lautstärkeeinstellung ein ungestörtes NF-Signal übertragen. Bei dieser bekannten Schaltungsanordnung sind die beiden Widerstände am Eingang des kapazitiv angeschlossenen Differenzverstärkers gemeinsam über eine Konstantspannungsquelle mit Bezugspotential verbunden. Maßnahmen gegen unerwünschte Störsignale sind hierbei nicht vorgesehen.

Die GB-A 2 111 334 beschreibt eine Muting-Schaltung, bei der mittels eines Schalters an einem Eingang eines Differenzverstärkers in stumm zu schaltenden Zeiträumen am Ausgang des Differenzverstärkers ein festes Gleichspannungspotential hergestellt wird. GB-A 2 151 887 gibt eine Schaltung zur Unterdrückung von Popp-Geräuschen an, bei der ein Hochpaßfilter vor einem Verstärker über einen Schalter aktivierbar ist. Der Schalter wird von einem Komparator gesteuert, der die Schaltschwelle festlegt.

Lineare Differenzverstärker mit hoher Verstärkung, sog. Operationsverstärker, müssen kapazitiv angekoppelt werden, wenn die Signalgleichspannung nicht definiert oder so groß ist, daß der Verstärker einseitig begrenzt. Bei kapazitiver Einkopplung liegt am Verstärkereingang die Mittenspannung, welcher die Wechselspannung überlagert ist. Die Übertragung der Wechselspannung wird von der Zeitkonstanten

$\tau = R_e \cdot C$ beeinflußt (C = Koppelkapazität, $R_e$ = Widerstandswert des Eingangswiderstandes des Verstärkers). Um Signalverzerrungen klein zu halten, muß die Zeitkonstante größer als die größte Signalperiode sein. Andererseits darf die Zeitkonstante nicht beliebig groß sein, damit der Verstärker bei einem Störsignal großer Amplitude in endlicher Zeit den Sollarbeitspunkt wieder erreicht.

Besonders in Fällen, wo die Signalspannung einer Lichtintensität proportional ist, kommt es zu sehr hoher Dynamik und zu Störsignalen, welche das Nutzsignal z.B. um den Faktor 1000 übersteigen können. Einmalige Störsignale dieser Art führen dazu, daß infolge der endlichen Zeitkonstante kurzzeitig ein hoher Verschiebestrom im Koppelkondensator fließt, so daß der Verstärker nach dem Störimpuls mit entgegengesetzter Polarität übersteuert wird, bis der Kondensator wieder umgeladen ist. Bei der Bildübertragung können solche Störungen periodisch auftreten. In diesem Fall wird der Verstärker, abhängig von Amplitude und Tastverhältnis der Störsignale, beidseitig in die Begrenzung gesteuert. Information, welche im Kleinsignal enthalten ist, geht dabei vollständig verloren, da sich am Verstärkereingang kein geeigneter Ruhearbeitspunkt einstellt.

Um die mit der Übersteuerung eines Verstärkers verbundene Totzeit (Erholzeit nach der Übersteuerung) zu vermindern, ist es bekannt, mittels Dioden im Gegenkopplungszweig die Verstärkung bei großen Eingangssignalen zu begrenzen (siehe z.B. Tietze-Schenk, 5. Auflage, S. 409). Die Verschiebung des Arbeitspunktes aufgrund kapazitiver Signaleinkopplung wird dabei jedoch nicht behoben. Die Verstärkung von Kleinsignalen, welche unmittelbar einem Störimpuls folgen, wird dadurch stark reduziert, bis sich der Arbeitspunkt wieder eingestellt hat.

Der Erfindung liegt die Aufgabe zugrunde, eine Schaltung anzugeben, welche eine erdfreie lineare Verstärkung von Kleinsignalen ermöglicht, ohne durch störende Großsignale, welche nicht linear übertragen werden sollen, eine Arbeitspunktverschiebung vom Sollarbeitspunkt zu erfahren. Insbesondere soll eine Schaltungsanordnung angegeben werden, welche in Bipolartechnik auf möglichst kleiner Chipfläche monolithisch integrierbar ist.

Aus Tietze, U.; Schenk, Ch.: Halbleiter-Schaltungstechnik, 3, Aufl., Springer Verlag, Berlin 1974, S. 294 - 295 ist ein steuerbarer elektronischer Schalter an den Eingängen eines Differenzverstärkers bereits bekannt. Der dort gezeigte Schalter kehrt jedoch lediglich die Polarität der Ausgangsspannung um. Eine Arbeitspunktverschiebung vom Sollarbeitspunkt aufgrund störender Großsignale und die damit verbundene Problematik ist dort jedoch nicht angesprochen.

Aus der US-PS 4 405 901 ist eine Schaltung zur Signalverstärkung eines Signals mit einem Gleichanteil mittels Differenzverstärkern bekannt, bei der das Signal an mehrere Differenzverstärker angeschaltet wird, ohne daß ein Gleichspannungs-Offset verursacht wird. Maßnahmen gegen störende Großsignale sind nicht vorgesehen.

Die der Erfindung zugrunde liegende Aufgabe durch die Schaltungsanordnung nach Anspruchs 1 gelöst. Dadurch, daß der Eingangswiderstand des Differenzverstärkers beim Überschreiten eines vorgegebenen Signalpegels hochohmig gesteuert wird, wird der Koppelkondensator nicht umgeladen, so daß sofort nach Verschwinden der Übersteuerung die Schaltungsanordnung die ursprüngliche lineare Kleinsignalverstärkung zeigt.

Vorteilhafte Ausgestaltungen und Weiterbildungen der Erfindung sind in den Unteransprüchen angegeben. Bei Ausgestaltung der Erfindung nach Anspruch 2 erscheint bei einer Übersteuerung der Schaltungsanordnung am Verstärkerausgang zur Kennzeichnung des Vorliegens eines Großsignals eine vorgegebene Maximalspannung. Außerdem ist das Ausgangssignal in vorteilhafter Weise transientenfrei. Bei Ausgestaltung der Erfindung nach Anspruch 3 läßt sich in einfacher Weise der Eingangsspannungsbereich, der linear verstärkt werden soll, in Abhängigkeit von der gewählten Signalverstärkung einstellen. Durch vorgeschaltete Emitterfolger gemäß Anspruch 4 erhöht sich nicht nur der Eingangswiderstand der Schaltungsanordnung, sondern ist auch unabhängig von der eingestellten Verstärkung. Die Ausgestaltung der Erfindung nach Anspruch 5 dient der Kompensation des Eingangsruhestromes des Verstärkers, welcher während der Großsignaldauer dem Koppelkondensator entzogen wird.

Die Erfindung wird im folgenden durch Ausführungsbeispiele und Zeichnungen näher erläutert. Es zeigen im einzelnen:

FIG. 1 Schaltungsanordnung gemäß der Erfindung mit einem Differenzverstärker;

FIG. 2 Schaltungsanordnung gemäß der Erfindung mit einem zweiten umschaltbaren Differenzverstärker;

FIG. 3 Schaltbild des Komparators mit Vorverstärker;

FIG. 4 Schaltbild des Verstärkereingangs mit Emitterfolger und Stromspiegel zur Basisstromkompensation.

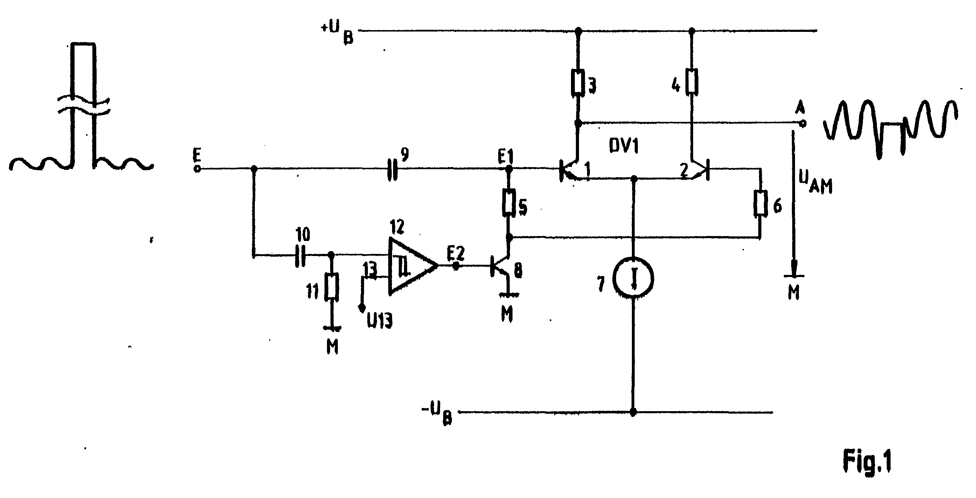

In FIG. 1 ist eine Schaltungsanordnung zur Signalverstärkung mittels eines Differenzverstärkers DV1, bestehend aus den Transistoren 1 und 2 und den Kollektorwiderständen 3 und 4, sowie der Emitterstromquelle 7, in ihrer einfachsten Form dargestellt. Die Signaleinkopplung erfolgt über den Eingang E und den Kondensator 9. Der Eingang E1 des Differenzverstärkers, an dem der Kondensator 9 angeschlossen ist, ist über einen Widerstand 5 und der andere Eingang über einen Widerstand 6 gemeinsam über einen elektronischen Schalter, der im Ausführungsbeispiel als Transistor 8 ausgebildet ist, mit Bezugspotential M verbunden.

Der als elektronischer Schalter vorgesehene Transistor 8 ist von einem Komparator 12 steuerbar. An dem einen Eingang des Komparators ist eine Referenzspannungsquelle 13 und an dem anderen Eingang ein RC-Glied, bestehend aus dem Widerstand 11 und dem Kondensator 10 angeschlossen, wobei der Kondensator zwischen dem einen Eingang des Komparators und dem Eingang der Schaltungsanordnung geschaltet ist.

Bei normalem Betrieb ist der Transistor 8 leitend und der Eingangswiderstand der Schaltungsanordnung, gemessen zwischen den Klemmen E1 und M, wird durch die Widerstände 5 und 6 bestimmt, welche die Bedingung

$$R_8 \ll (R_5, R_6) \ll R_{id}$$

erfüllen. Dabei ist $R_8$ der Durchschaltwiderstand des Transistors 8 und

$$R_{id} = 2 \cdot (R_B + \beta \cdot \frac{U_T}{I_7})$$

der differentielle Eingangswiderstand des Differenzverstärkers ohne die Widerstände 5 und 6. Ferner ist $R_B$ der Basisbahnwiderstand eines Transistors 1 oder 2, $U_T$ die Temperaturspannung eines Transistors ($\approx 26$ mV bei 25°C) und $I_7$ der Strom der Emitterstromquelle 7.

Zur erdfreien Signaleinkopplung dient der Kondensator 9. Über einen zweiten Kondensator 10 wird das Eingangssignal in einen als Komparator 12 ausgeführten Pegeldetektor eingekoppelt.

Die Zeitkonstanten $R_{11} \cdot C_{10}$ und $R_5 \cdot C_9$ sind zweckmäßigerweise gleich groß und so gewählt, daß sie etwa gleich groß der Signalperiode des Nutzsignals mit der tiefsten zu übertragenden Frequenz sind. Zur raschen Arbeitspunkteinstellung auf den Sollarbeitspunkt sollten sie nicht unnötig groß gewählt werden.

Bei Großsignalstörungen, z.B. mit Signalen, die 40 dB über dem Nutzsignal liegen, sperrt der Komparator 12 den Transistor 8. Da die Widerstände $R_5$ und $R_6$ sehr viel kleiner als der differentielle Eingangswiderstand der Transistoren 1 und 2 sind, erfährt die Differenzverstärkerstufe eine Gleichtaktansteuerung, wobei der Eingangswiderstand des Differenzverstärkers zwischen den Klemmen E1 und der Bezugsleitung M wegen des hohen differentiellen Widerstandes $R_7$ der Stromquelle 7 den hohen Wert

$$R_{E1M} = \beta \cdot R_7 \gg R_5$$

annimmt. Damit ergibt sich die sehr große Zeitkonstante $C_9 \cdot R_{E1M}$, welche einen Verschiebestrom im Kondensator $C_9$ während der Großsignalaussteuerung verhindert.

Wenn die abfallende Flanke des Großsignals die Komparatorschwelle unterschreitet, wird der Transistor 8 wieder leitend, und die Differenzverstärkerstufe wird ohne Arbeitspunktverschiebung und Kapazitätsumladung des Kondensators 9 wieder linear betrieben. Die Komparatorschwelle $U_{13}$ am Eingang 13 des Komparators 12 wird zweckmäßigerweise so eingestellt, daß die Umschaltung der Zeitkonstanten erfolgt, kurz bevor das Eingangssignal den Differenzverstärkerausgang A in die Begrenzung steuert.

Die Differenzverstärkerstufe DV1 ist aus Laufzeitgründen zweckmäßigerweise so zu dimensionieren, daß die Transistoren 1 und 2 durch die Amplitude eines maximal zu erwartenden Großsignals nicht in die Sättigung gesteuert werden.

Die Schaltungsanordnung ist damit in der Lage, Kleinsignale ohne Arbeitspunktverschiebung durch Großsignale linear zu verstärken. Das Ausgangssignal $U_{AM}$ am Ausgang A des Verstärkers fällt jedoch bei Vorliegen eines Großsignals nach Erreichen der Maximalspannung auf die der Gleichtaktverstärkung

$$V = R_3/(2 \cdot R_7)$$

entsprechende Ausgangsspannung zurück, was außerdem zu Transienten führt.

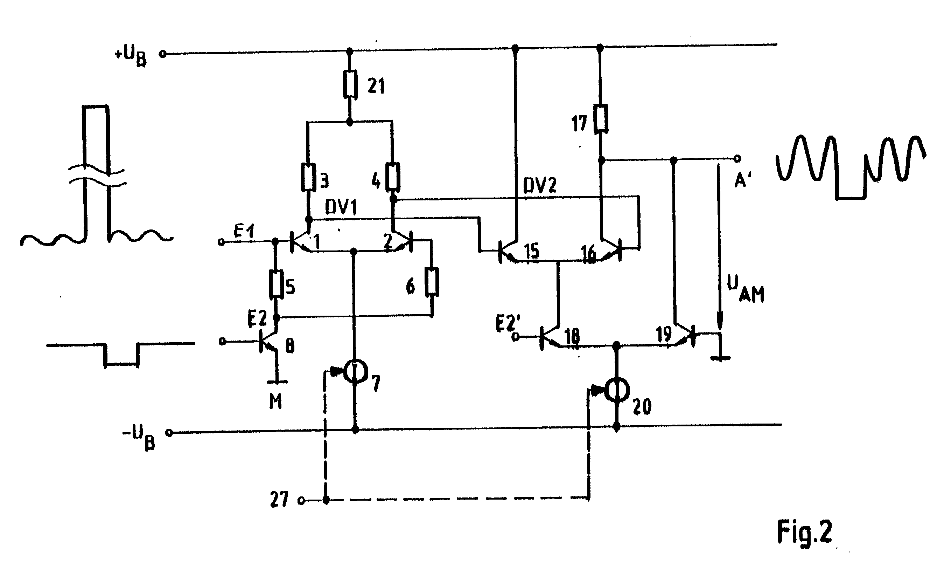

In der Regel ist die Information "große Signale" am Ausgang des Verstärkers erwünscht, so daß zweckmäßigerweise während der Dauer eines am Eingang anliegenden Großsignals am Verstärkerausgang ein vorgebbarer Maximalpegel liegen sollte. Dies wird in der Weiterbildung der Schaltungsanordnung gemäß FIG. 2 erreicht. Hier ist an den Kollektoren der Transistoren 1 und 2 ein zweiter Differenzverstärker DV2 mit zwei Transistoren 15 und 16 angeschlossen. Für die beiden Transistoren ist eine Emitterstromquelle 20 vorgesehen, die über einen von dem Komparator 12 über den Eingang E2' gesteuerten Wechselschalter, der im Ausführungsbeispiel aus den beiden Transistoren 18 und 19 besteht, in einem ersten Schaltzustand mit den zusammengeschalteten Emittern der beiden Transistoren 15 und 16 und in einem zweiten Schaltzustand mit dem Ausgang A' des zweiten Differenzverstärkers DV2 verbindbar ist.

Ein Widerstand 21, zwischen der die Betriebsspannung +$U_B$ führenden Leitung und dem Verbindungspunkt der beiden Kollektorwiderstände 3 und 4 des ersten Differenzverstärkers dient in an sich bekannter Weise zur Potentialverschiebung der Kollektorspannung der Transistoren 1 und 2 und damit der Basisspannungen der Transistoren 15 und 16.

Im Normalfall, also bei Kleinsignal, sind die Transistoren 8 und 18 leitend, während Transistor 19 gesperrt ist. Der Strom der Stromquelle 20 fließt dann durch die Transistoren 15 und 16 des zweiten Differenzverstärkers DV2 und bewirkt eine lineare Verstärkung auch des zweiten Differenzverstärkers. Der Eingangswiderstand $R_{E1M}$ zwischen der Eingangsklemme E1 und Bezugsleitung M wird durch den Widerstand 5 bestimmt.

Ein übersteuerndes Großsignal steuert den Verstärkerausgang A' zunächst fast in die Begrenzung. Bei Erreichen der zur Begrenzung gehörenden Eingangsspannung $U_{E1M}$ werden die Transistoren 8 und 18 gesperrt und 19 durchgeschaltet. Dabei fließt der gesamte Strom der Stromquelle 20 durch den Widerstand 17 im Kollektor des Transistors 16 und hält die dem Begrenzungszustand entsprechende Ausgangsspannung $U_{AMmax}$ konstant, bis wieder bei Verschwinden des Großsignals die Umschaltung in den linearen Betriebszustand erfolgt.

Der Verstärkereingang ist, wie bereits beschrieben, während der Dauer des Großsignals hochohmig. Das Verstärkerausgangssignal zeigt dabei jedoch nicht das mit der Gleichtaktverstärkung multiplizierte Eingangssignal, sondern den durch die Betriebsspannungen +$U_B$, -$U_B$, die Stromquelle 20 und den Widerstand 17 vorgegebenen maximalen Ausgangspegel. Bei gleichzeitiger Ansteuerung der Transistoren 8 und 18 durch den Komparator 12 ist in vorteilhafter Weise das Ausgangssignal $U_{AM}$ transientenfrei.

Falls, wie FIG. 1 und 2 zeigen, keine Widerstände in Reihe mit den Emittern der Transistoren 1, 2, 15 und 16 liegen, läßt sich die Verstärkung der Schaltungsanordnung durch steuerbare Stromquellen 7 und 20 einstellen. Dabei ändert sich jedoch der Wert der Eingangsspannung, bei welcher am Verstärkerausgang A' die Begrenzung eintritt. Da der Komparator 12 bei Überschreiten der konstanten Komparatorschwelle $U_{13}$, die gleich der maximal zulässigen Eingangsspannung gewählt ist, umschaltet, ist die Dynamik für lineare Übertragung nur bei einer diskreten Verstärkung des Signalverstärkers optimal.

Bei niedriger eingestellter Verstärkung des Signalverstärkers erfolgt die Umschaltung auf Großsignal schon bei Eingangssignalpegel, die noch linear übertragen werden könnten. Dies führt bei jedem Umschalten zu einem Spannungssprung am Ausgang A'. Dagegen kann bei hoher eingestellter Verstärkung des Signalverstärkers der Signalverstärker schon mit Kleinsignal in die Begrenzung gesteuert werden, ohne daß die gewünschte Umschaltung erfolgt.

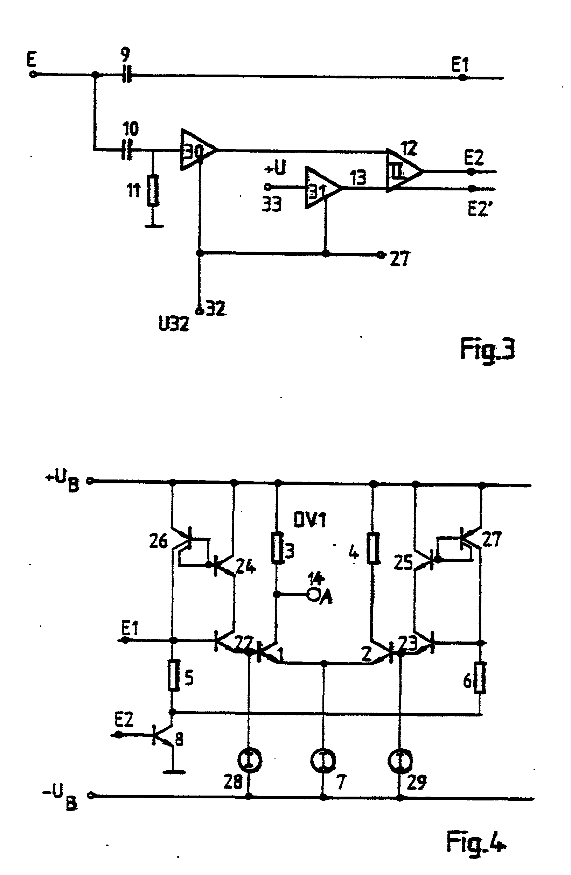

Diese Nachteile werden mit der Schaltungsanordnung gemäß FIG. 3 dadurch vermieden, daß die Komparatorschwelle $U_{13}$ der jeweiligen maximal zulässigen Eingangsspannung $U_{E1max}$ = $U_{AMmax}/V$ und damit der Verstärkung des Signalverstärkers angepaßt wird.

In FIG. 3 ist der Verstärkereingang zwischen der Eingangsklemme E und den Klemmen E1 und E2 dargestellt. Gleiche Elemente wie in FIG. 1 sind mit den gleichen Bezugszeichen versehen. Wie ersichtlich, ist dem Signaleingang des Komparators 12 ein Vorverstärker 30 und dem Referenzeingang des Komparators 12 ein Vorverstärker 31 vorgeschaltet. Beide Vorverstärker 30 und 31 sind in der Verstärkung in gleicher Weise wie der Signalverstärker (DV1 mit DV2) steuerbar. Hierzu sind ihre Steuereingänge zusammengeschaltet und über eine gemeinsame Steuerleitung 32, die mit dem Steuereingang 27 der Stromquellen 7 und 20 (Fig. 2) verbunden ist, durch eine einstellbare Steuerspannung $U_{32}$ steuerbar.

Damit die Vorverstärker 30 und 31 eine möglichst identische Verstärkung und einen möglichst identischen Verstärkungsgang bei der Verstärkungssteuerung aufweisen, werden die Vorverstärker zweckmäßigerweise jeweils in gleicher Weise wie der Signalverstärker aufgebaut, wobei jedoch die Widerstände 5 und 6 des Differenzverstärkers DV1 direkt an Bezugspotential M anzuschließen sind und unter Einsparung der Transistoren 18 und 19 des Differenzverstärkers DV2 die steuerbare Stromquelle 20 direkt mit den Emittern der Transistoren 15 und 16 zu verbinden ist. Im Falle des Vorverstärkers 30 entspricht dann z.B. der Widerstand 11 an seinem Eingang (Fig. 3) dem Widerstand 5 des Differenzverstärkers DV1 in FIG. 2.

Der Vorverstärker 31 hat die Aufgabe, die Referenzspannung und damit den Umschaltpunkt der jeweils maximalen Ausgangsspannung $U_{AM}$ des Signalverstärkers, die abhängig von der eingestellten Verstärkung, der Betriebsspannung und unabhängig von der über der Spannung $U_{32}$ eingestellten Verstärkung und unabhängig von der Betriebstemperatur und der Versorgungsspannung linear bis zum maximalen Ausgangspegel am Ausgang A' und schaltet bei Erreichen dieses Pegels die Eingangszeitkonstante des Signalverstärkers um.

In FIG. 4 ist eine vorteilhafte Ausgestaltung der ersten Differenzverstärkerstufe DV1, die die Transistoren 1 und 2 enthält, dargestellt. Hierbei ist den Transistoren 1 und 2 jeweils ein Emitterfolger 22 und 23 vorgeschaltet und die Widerstände 5 und 6 sind an den jeweiligen Basiselektroden der Emitterfolger angeschlossen. Hierdurch wird der Eingangswiderstand des ersten Differenzverstärkers in vorteilhafter Weise erhöht, verstärkungsunabhängig und vernachlässigbar gegenüber den Widerständen 5 und 6. Die Emitterfolger verringern außerdem den Eingangsruhestrom des Verstärkers. Ferner reduzieren sie bei gesperrtem Transistor 8 den Eingangsruhestrom der Transistoren 1 und 2, der bei längerem Anliegen eines Großsignals in unerwünschter Weise eine Umladung des Kondensators 9 und damit eine Arbeitspunktverschiebung bewirken würde.

Ferner zeigt FIG. 4, daß in der Kollektorleitung eines jeden Emitterfolgers 22 und 23 ein zusätzlicher Transistor 24 bzw. 25 geschaltet ist, deren Basisanschlüsse an einer mit der Stromversorgungsleitung, welche die Spannung +$U_B$ führt, verbundenen Stromspiegelschaltung 26 bzw. 27 angeschlossen sind. Der den jeweils gespiegelten Strom führende Kollektor der Stromspiegelschaltung 26 bzw. 27 ist mit der Basis des entsprechenden Emitterfolgers 22 bzw. 23 verbunden. Da z.B. der Transistor 24 den gleichen Basisstrom hat wie der Transistor 22, bewirkt sein über dem der Umgebungstemperatur ist, anzupassen. Beispielsweise wird beim Einstellen einer höheren Verstärkung der Strom der Stromquelle 20 des zweiten Differenzverstärkers DV2 erhöht. Im Falle der Signalverstärkerabschaltung bei Großsignal und dadurch leitendem Transistors 19 ist dann der Spannungsabfall durch den höheren Strom der Stromquelle 20 am Widerstand 17 größer und dadurch die Spannung $U_{AM}$ niedriger. Folglich ist zur Vermeidung von Transienten beim Umschalten die Referenzspannung für den Komparator 12 zu erniedrigen. Das bedeutet, daß der Vorverstärker 31 so geschaltet sein muß, daß bei einer Einstellung auf höhere Verstärkung seine Ausgangs(gleich)spannung abnimmt.

Der Eingang des Verstärkers 31 liegt auf einem konstanten Potential, das in der Figur mit +U bezeichnet ist. Der Betrag der konstanten Eingangsspannung +U ist so gewählt, daß der Ausgang 13 des Vorverstärkers 31, unabhängig von der eingestellten Verstärkung, im Begrenzungszustand gehalten wird. Das bedeutet, daß im Vorverstärker 31 der dem Differenzverstärker DV2 entsprechende Transistor stets leitend gesteuert ist.

Ferner ist die Ausgangsspannung des Vorverstärkers 31 geringfügig kleiner (etwa 5 - 10%) als die maximale Ausgangsspannung des Vorverstärkers 30 und damit auch des Signalverstärkers.

In vorteilhafter Weise läßt sich mit der Verstärkungseinstellung über die Spannung $U_{32}$ der Eingangsspannungsbereich des Signalverstärkers einstellen, der linear verstärkt werden soll. Die Schaltungsanordnung gemäß FIG. 2, ergänzt mit der Schaltung gemäß FIG. 3, arbeitet dann Stromspiegel 26 gespiegelter Basisstrom die Kompensation des Basisstromes des Transistors 22, so daß nun auch nach längerem Sperren des Transistors 8 durch ein Großsignal anschließend der Sollarbeitspunkt praktisch ohne Abweichung erreicht wird.

**Patentansprüche**

1. Schaltungsanordnung zur Signalverstärkung mittels eines Differenzverstärkers (DV1) und eines ersten Kondensators (9) an einem seiner beiden Eingänge zur Signaleinkopplung, bei der der eine Eingang des Differenzverstärkers (DV1), an dem der erste Kondensator (9) angeschlossen ist, über einen ersten Widerstand (5) und der andere Eingang des Differenzverstärkers (DV1) über einen zweiten Widerstand (6) gemeinsam über ein Bauelement mit Bezugspotential (M) verbunden sind, dadurch gekennzeichnet, daß das Bauelement ein elektronischer Schalter (8) ist, daß der elektronische Schalter (8) von einem Komparator (12) steuerbar ist, daß an dem einen Eingang des Komparators (12) eine Referenzspannungsquelle ($U_{13}$) und an dem anderen Eingang ein RC-Glied (11, 10) angeschlossen sind, daß der Widerstand (11) des RC-Gliedes an Bezugspotential (M) und der Kondensator (10) des RC-Gliedes an den Eingang (E) der Schaltungsanordnung angeschlossen sind, und daß die durch den ersten Kondensator (9) und den ersten Widerstand (5) gebildete Zeitkonstante in der Größenordnung der Zeitkonstante des RC-Gliedes (10, 11) des Komparators (12) liegt und wesentlich kleiner als die durch den ersten Kondensator (9) und den Eingangswiderstand des Differenzverstärkers (DV1) gebildete Zeitkonstante und etwa gleich groß der Signalperiode des Nutzsignals mit der tiefsten zu übertragenden Frequenz ist.

2. Schaltungsanordnung nach Anspruch 1, dadurch gekennzeichnet, daß der Differenzverstärker (erste Differenzverstärker DV1) zwei Transistoren (1, 2) mit einer gemeinsamen Emitterstromquelle (7) und mit gleich großen Kollektorwiderständen (3, 4) enthält, daß an den Kollektoren der beiden Transistoren (1, 2) des ersten Differenzverstärkers (DV1) ein zweiter Differenzverstärker (DV2) mit zwei Transistoren (15, 16) angekoppelt ist, daß für die beiden Transistoren (15, 16) des zweiten Differenzverstärkers (DV2) eine zweite Emitterstromquelle (20) vorgesehen ist, die über einen von dem Komparator (12) gesteuerten Wechselschalter (18, 19) in einem ersten Schaltzustand mit den zusammengeschalteten Emittern der beiden Transistoren (15, 16) des zweiten Differenzverstärkers (DV2) und in einem zweiten Schaltzustand mit dem Ausgang (A') des zweiten Differenzverstärkers (DV2) verbindbar ist.

3. Schaltungsanordnung nach Anspruch 2, dadurch gekennzeichnet, daß die gemeinsame Emitterstromquelle (7) und die zweite Emitterstromquelle (20) als steuerbare Stromquellen ausgebildet sind und mittels der steuerbaren Stromquellen (7, 20) die Verstärkung des aus ersten und zweiten Differenzverstärker (DV1, DV2) gebildeten Signalverstärkers einstellbar ist, daß dem Signaleingang des Komparators (12) ein erster Vorverstärker (30) und dem Referenzeingang des Komparators (12) ein zweiter Vorverstärker (31) vorgeschaltet sind, daß beide Vorverstärker (30, 31) in der Verstärkung in gleicher Weise steuerbar sind wie der Signalverstärker (DV1, DV2), daß die maximale Ausgangsspannung des Vorverstärkers (30) identisch mit der des Signalverstärkers (DV1, DV2) und die des Vorverstärkers (31) geringfügig kleiner als die des Signalverstärkers (DV1, DV2) ist und daß der Ausgang (13) des Vorverstärkers (31) über dessen Eingang (33), unabhängig von der eingestellten Verstärkung, im Begrenzungszustand gehalten wird.

4. Schaltungsanordnung nach einem der vorangegangenen Ansprüche, dadurch gekennzeichnet, daß den Transistoren (1, 2) des ersten Differenzverstärkers (DV1) jeweils ein Emitterfolger (22, 23) vorgeschaltet ist und die ersten und zweiten Widerstände (5, 6) an den jeweiligen Basiselektroden der Emitterfolger (22, 23) angeschlossen sind.

5. Schaltungsanordnung nach Anspruch 4, dadurch gekennzeichnet, daß in die Kollektorleitung eines Emitterfolgers (22) ein zusätzlicher Transistor (24) geschaltet ist, dessen Basis an einer mit der Stromversorgungsleitung (+UB) des Kollektors verbundenen Stromspiegelschaltung (26) angeschlossen ist und der den gespiegelten Strom führende Kollektor der Stromspiegelschaltung (26) mit der Basis des Emitterfolgers (22) verbunden ist.

**Claims**

1. Circuit arrangement for signal amplification by means of a differential amplifier (DV1) and a first capacitor (9) for the coupling-in of signals at one of both its inputs, in which the one input of the differential amplifier (DV1), to which the first capacitor (9) is connected, is connected by way of a first resistor (5) and the other input of the differential amplifier (DV1) is connected by way of a second resistor (6) in common by way of a component with reference potential (M), characterised thereby, that the component is an electronic switch (8), that the electronic switch (8) is controllable by a comparator (12), that a reference voltage source (U13) is connected to the one input of the comparator (12) and an RC member (11, 10) is connected to the other input of the comparator (12), that the resistor (11) of the RC member is connected to reference potential (M) and the capacitor (10) of the RC member is connected to the input (E) of the circuit arrangement and that the time constant formed by the first capacitor (9) and the first resistor (5) lies in the order of magnitude of the time constant of the RC member (10, 11) of the comparator (12) and is substantially smaller than the time constant formed by the first capacitor (9) and the input resistance of the differential amplifier (DV1) and about equally great as the signal period of the useful signal of the lowest frequency to be transmitted.

2. Circuit arrangement according to claim 1, characterised thereby, that the differential amplifier (first differential amplifier DV1) contains two transistors (1, 2) with a common emitter current source (7) and with equally great collector resistors (3, 4), that a second differential amplifier (DV2) with two transistors (15, 16) is coupled to the collectors of both the transistors (1, 2) of the first differential amplifier (DV1), that a second emitter current source (20) is provided for both the transistors (15, 16) of the second differential amplifier (DV2) and is connectable by way of a changeover switch (18, 19) controlled by the comparator (12) in a first switch state with the interconnected emitters of both the transistors (15, 16) of the second differential amplifier (DV2) and in a second switching state with the output (A') of the second differential amplifier (DV2).

3. Circuit arrangement according to claim 2, characterised thereby, that the common emitter current source (7) and the second emitter current source (20) are constructed as controllable current sources and the amplification of the signal amplifier formed of the first and the second differential amplifier (DV1, DV2) is settable by means of the controllable current sources (7, 20), that a first pre-amplifier (30) is connected in front of the signal input of the comparator (12) and a second pre-amplifier (31) is connected in front of the reference input of the comparator (12), that both pre-amplifiers (30, 31) are controllable in the amplification in like manner as the signal amplifier (DV1, DV2), that the maximum output voltage of the preamplifier (30) is identical with that of the signal amplifier (DV1, DV2) and that of the pre-amplifier (31) is slightly smaller than that of the signal amplifier (DV1, DV2) and that the output (13) of the pre-amplifier (31) is kept in the limiting state by way of its input (33) independently of the set amplification.

4. Circuit arrangement according to one of the preceding claims, characterised thereby, that a respective emitter follower (22, 23) is connected in front of each of the transistors (1, 2) of the first differential amplifier (DV1) and the first and second resistor (5, 6) are each connected to the respective base electrodes of the emitter followers (22, 23).

5. Circuit arrangement according to claim 4, characterised thereby, that an additional transistor (24) is connected into the collector line of an emitter follower (22), the base of which transistor is connected to a current-imaging circuit (26) connected with the current supply line (+UB) of the collector and the collector, conducting the imaged current, of the current-imaging circuit (26) is connected with the base of the emitter follower (22).

**Revendications**

1. Montage pour amplifier des signaux au moyen d'un amplificateur différentiel (DV1) et d'un premier condensateur (9) prévu à l'une de ses deux entrées pour l'injection de signaux, dans lequel l'une des entrées de l'amplificateur différentiel (DV1), à laquelle est connecté le premier condensateur (9), est reliée à travers une première résistance (5) et l'autre entrée de l'amplificateur différentiel (DV1) est reliée à travers une deuxième résistance (6) au potentiel de base ou potentiel de la masse (M) à travers un composant commun, caractérisé en ce que le composant est un interrupteur électronique (8),
que cet interrupteur électronique (8) peut être commandé par un comparateur (12),
qu'une source de tension de référence (U13) est branchée sur l'une des entrées du comparateur (12) et un élément RC (11, 10) est branché sur l'autre entrée du comparateur (12),
que la résistance (11) de l'élément RC est connectée au potentiel de la masse (M) et le condensateur (10) de l'élément RC est connecté à l'entrée (E) du montage, et
que la constante de temps définie par le premier condensateur (9) et la première résistance (5) est de l'ordre de grandeur de la constante de temps de l'élément RC (10, 11) du comparateur (12), nettement inférieure à la constante de temps définie par le premier condensateur (9) et la résistance d'entrée de l'amplificateur différentiel (DV1) et environ égale à la période du signal utile ayant la plus basse fréquence à transmettre.

2. Montage selon la revendication 1, caractérisé en ce que l'amplificateur différentiel (premier amplificateur différentiel DV1) comporte deux transistors (1, 2) ayant une source de courant d'émetteurs (7) commune et ayant des résistances de collecteur (3, 4) d'égale grandeur

qu'un deuxième amplificateur différentiel (DV2) possédant deux transistors (15, 16) est couplé aux collecteurs des deux transistors (1, 2) du premier amplificateur différentiel (DV1), et

qu'une deuxième source de courant d'émetteurs (20) est prévue pour les deux transistors (15, 16) du deuxième amplificateur différentiel (DV2), source de courant (20) qu'un inverseur (18, 19) commandé par le commandé (12) peut connecter, à une première position, aux émetteurs reliés ensemble des deux transistors (15, 16) du deuxième amplificateur différentiel (DV2) et, à une deuxième position, à la sortie (A') du deuxième amplificateur différentiel (DV2).

3. Montage selon la revendication 2, caractérisé en ce que la source de courant d'émetteurs commune (7) et la deuxième source de courant d'émetteurs (20) sont réalisées comme des sources de courant pouvant être commandées et que l'amplification de l'amplificateur de signaux, formé par les premier et deuxième amplificateurs différentiels (DV1, DV2), est réglable au moyen des sources de courant (7, 2) commandées,

que l'entrée de signal du comparateur (12) est précédée d'un premier préamplificateur (31) et l'entrée de référence du comparateur (12) est précédée d'un deuxième préamplificateur (31),

que l'amplification des deux préamplificateurs (30, 31) est réglable de la même manière que celle de l'amplificateur de signaux (DV1, DV2),

que la tension de sortie maximale de l'un (30) des préamplificateurs est égale à celle de l'amplificateur de signaux (DV1, DV2) et la tension de sortie maximale de l'autre préamplificateur (31) est légèrement inférieure à celle de l'amplificateur de signaux (DV1, DV2) et

que la sortie (13) du préamplificateur (31) mentionné en dernier est maintenue, à l'état de limitation, par son entrée (33) indépendamment de l'amplification réglée.

4. Montage selon l'une des revendications précédentes, caractérisé en ce que les transistors (1, 2) du premier amplificateur différentiel (DV1) sont précédés chacun d'un émetteur-suiveur (22, 23) et les première et deuxième résistances (5, 6) sont connectées aux électrodes de base correspondantes des émetteurs-suiveurs (22, 23).

5. Montage selon la revendication 4, caractérise en ce que la ligne de collecteur d'un émetteur-suiveur (22) contient un transistor (24) supplémentaire dont la base est raccordée à un circuit de courant symétrique (26) relié à la ligne d'alimentation (+U$_B$)

et le collecteur, traversé par le courant symétrisé de ce circuit (26), est relié à la base de l'émetteur-suiveur (22).

Fig.1

EP 0 218 179 B1

Fig.2

EP 0 218 179 B1

Fig.3

Fig.4